(19) **Europäisches Patentamt**

**European Patent Office**

**Office européen des brevets**

(11) **EP 0 681 326 B1**

(12) **EUROPEAN PATENT SPECIFICATION**

(45) Date of publication and mention
of the grant of the patent:
**25.06.2003 Bulletin 2003/26**

(51) Int Cl.[7]: **H01L 21/8248**, H01L 29/745

(21) Application number: **95302799.2**

(22) Date of filing: **26.04.1995**

(54) **Semi-conductor device and method of manufacturing the same**

Halbleitervorrichtung und Verfahren zu deren Herstellung

Dispositif semi-conducteur et procédé pour fabriquer celui-ci

(84) Designated Contracting States:
**CH DE GB LI SE**

(30) Priority: **28.04.1994 JP 9235194**

(43) Date of publication of application:
**08.11.1995 Bulletin 1995/45**

(73) Proprietor: **NGK INSULATORS, LTD.**
**Nagoya City Aichi Pref. (JP)**

(72) Inventor: **Terasawa, Yoshio**
**Katsuta City, Ibaraki Pref. (JP)**

(74) Representative: **Paget, Hugh Charles Edward et al**
**MEWBURN ELLIS**
**York House**
**23 Kingsway**
**London WC2B 6HP (GB)**

(56) References cited:
**EP-A- 0 014 080    US-A- 4 528 745**
**US-A- 4 974 061    US-A- 5 153 695**

- **STANLEY WOLF: "Silicon processing in the VLSI era, vol. 2: Process integration", 1990, LATTICE PRESS, SUNSET BEACH, CA**

## Description

Background of the Invention

Field of the Invention

The present invention relates to a semiconductor device and a method of manufacturing the same, and more particularly to a power semiconductor device having a high breakdown voltage, and to a method of manufacturing such a power semiconductor device.

Description of the Related Art

In the conventional power semiconductor devices, a semiconductor layer is generally formed in a surface of a semiconductor substrate by an impurity diffusion. Since such power semiconductor devices are required to have a high breakdown voltage, the impurity-diffused layer formed in the surface of the semiconductor substrate should have, when viewed in a cross section perpendicular to the substrate surface, a rounded contour with a large radius of curvature to avoid a concentration of an electric field.

In order to obtain such impurity-diffused region having a gently curved cross sectional contour, it is necessary to perform the impurity diffusion very slowly during the selective doping of the surface of the semiconductor substrate. Specifically, the impurity diffusion should be conducted over several ten hours to a hundred hours, or even more. Accordingly, the throughput of such power semiconductor device is decreased, and the production cost of the device is increased. Moreover, since it is difficult to keep various producing conditions constant for such a long time, properties of the thus-obtained devices likely to fluctuate.

US-A-4528745 describes a method of formation of buried gates in a semiconductor device. Grooves are in a N-type substrate formed by dry or wet etching using an oxide film as a mask, and a P-type diffusion layer is formed on the inner surfaces of the grooves by diffusion of boron as an impurity, again using the oxide film as a mask. The grooves are then buried with a P-type epitaxial layer, to provide regions of different values of P-type impurity concentration. The grooves are illustrated as rectangular.

US-A-4974061 illustrates a planar type heterostructure avalanche photodiode having a guard ring formed by ion implantation around the periphery of a p$^+$-conduction region which is formed by Zn diffusion into a flat surface of a n-InP layer as a multiplication layer. The guard ring has a cross-section of curvature-relieved shape.

Summary of the Invention

It is therefore an object of the present invention to provide a novel semiconductor device and a method of manufacturing the same, which can remove or mitigate the above-mentioned drawbacks of the conventional semiconductor device and manufacturing method thereof.

According to the present invention, there is provided a semi-conductor device as set out in claim 1.

The method of manufacturing a semiconductor device according to the present invention is set out in claim 3.

As specified, in the semiconductor device according to the present invention, the recessed portion has a surface which includes curved portions, each of which is substantially identical to a part of a spheroid represented by the following formula:

$$x^2/a^2 + y^2/b^2 + z^2/c^2 = 1,$$

wherein x and y are orthogonal coordinates defining a plane which is parallel to the surface of the semiconductor substrate and z is a coordinate defining a position in a direction perpendicular to the x-y plane. Incidentally, such curved portions may include curved surfaces which deviate from one that is identical to a part of the spheroid by up to about ±10% in a distance from the revolution axis.

A recessed portion having such a structure as described above can be obtained by wet-etching the surface of the semiconductor substrate while using a mask which has an opening at such a position corresponding to a portion of the substrate surface at which the recessed portion is to be formed.

Accordingly, in the semiconductor device of the present invention, since impurities are diffused into the semiconductor substrate through the surface of the recessed portion, a semiconductor region having a sectional contour with a large radius of curvature can be obtained by conducting the doping for a very short time such as one to several hours. The gently curved contour of the impurity-diffused region scarcely causes a concentration of an electric field and therefore, the semiconductor device can have a higher breakdown voltage and is preferably used as a power semiconductor device. In addition, since the doping of the semiconductor substrate is conducted for a very short period of time in the present invention, an improvement is attained in the throughput of the manufacturing process of the semiconductor device. Moreover, the thus-obtained semiconductor devices can have stable and excellent properties because the producing conditions can be easily kept constant during the short-time doping.

Examples of the semiconductor device, to which the present invention is applicable, may include a thyristor, optical thyristor, GTO thyristor, static induction (SI) thyristor, SI transistor, power transistor, MOFSET, IGBT (insulated gate bipolar transistor) and the like.

Brief Description of the Drawings

The present invention will be explained in further detail with reference to the attached drawings.

Fig. 1 is a cross-sectional view showing an embodiment of the semiconductor device according to the present invention;
Fig. 2 is a plan view illustrating the semiconductor device shown in Fig. 1;
Figs. 3A to 3K are cross-sectional views depicting successive steps in an embodiment of the manufacturing method of a semiconductor device according to the present invention;
Fig. 4 is a diagram illustrating a configuration of a recessed portion which is formed by wet-etching in a manufacturing method of a semiconductor device according to the present invention; and
Figs. 5A and 5B are diagrams for explaining a configuration of a recessed portion formed by wet-etching.

Description of the Preferred Embodiments

Now, preferred embodiments of the present invention will be explained by referring to the attached drawings.

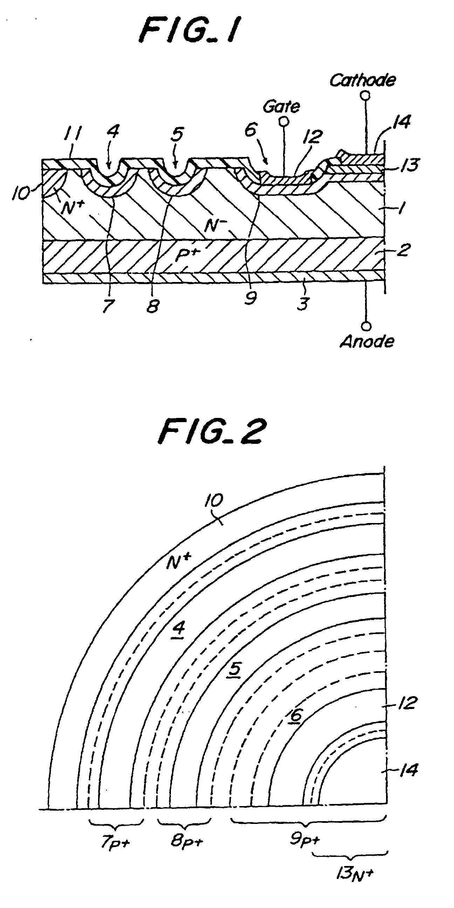

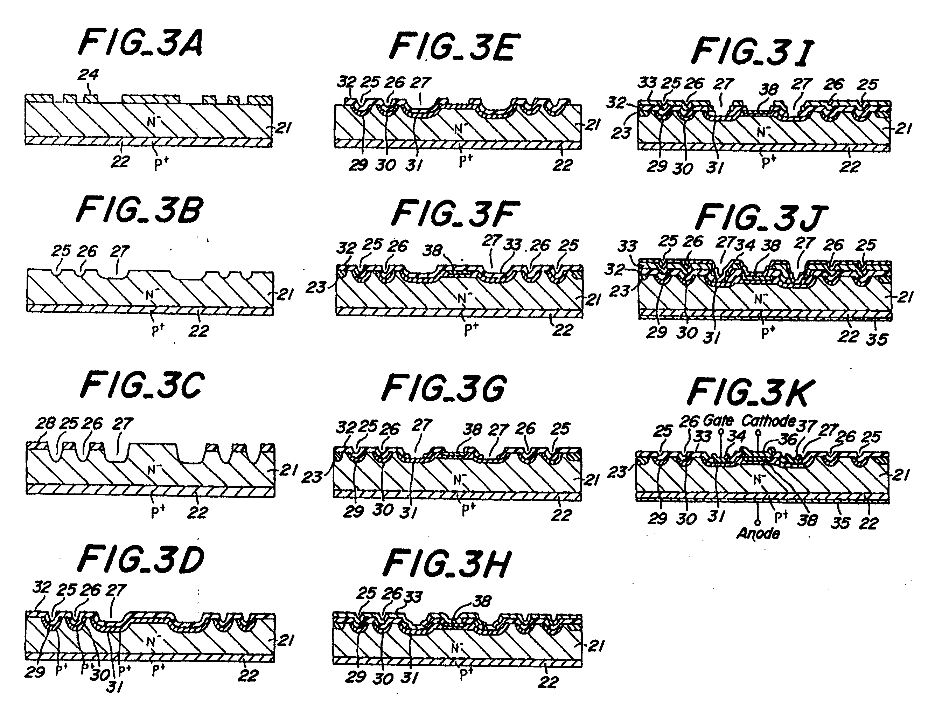

Fig. 1 is a cross-sectional view illustrating an embodiment of the semiconductor device according to the present invention, and Fig. 2 shows the same semiconductor device in plan. In this embodiment, the semiconductor device is of a thyristor.

A lower surface of an $N^-$-type semiconductor substrate 1 is doped with $P^+$-type impurities in great quantity to form a $P^+$-type region 2, and then an anode electrode 3 composed of an aluminum film is formed thereon. In an upper surface of the semiconductor substrate 1, there are formed a plurality of recesses, i.e. annular recessed portions 4, 5 and 6. Among them, the recessed portions 4 and 5 are produced for guard rings, and the recessed portion 6 is for a gate to be formed within the inner guard ring. In the present invention, $P^+$-type regions 7, 8 and 9 are formed by selectively doping the substrate 1 with impurities through surfaces of these recessed portions 4, 5 and 6. By diffusing impurities into the substrate 1 through the surfaces of the recessed portions 4, 5 and 6, the obtained $P^+$-type regions 7, 8 and 9 can have a sectional configuration with a gentle curve even when the impurity diffusion is performed for a very short period of time. As a result, a concentration of an electric field is effectively avoided in the semiconductor device according to the present invention.

Then, an $N^+$-type channel stopper 10 is formed in the $N^-$-type substrate 1 on the outside of the outer $P^+$-type region 7, which functions as one of the guard rings. Further, an $N^+$-type cathode region 13 is formed in a part of the $P^+$-type region 9. At this stage, a passivation layer 11 of silicon oxide covers all over the upper surface of the semiconductor substrate 1. After selectively removing this passivation layer 11 at positions corresponding to the $P^+$-type region 9 and the central region of the substrate, an aluminum film is provided on exposed surfaces of the $P^+$-type region 9 and $N^+$-type region 13 to form a gate electrode 12 and cathode electrode 14, respectively. In this connection, if the passivation layer 11 is replaced with a polyimide layer or a silicone layer in a peripheral portion of the substrate, the passivation effects are improved in this. portion, thereby raising the breakdown voltage of the semiconductor device.

According to the present invention, the semiconductor substrate 1 is doped with impurities through the recessed portions 4, 5 and 6 formed in the surface the substrate, and therefore each of the thus-obtained impurity-diffused regions 7, 8 and 9 can have a gently curved sectional contour in spite of the shortness of the time period in which the impurity diffusion is conducted. Accordingly, a concentration of an electric field hardly occurs in these impurity-diffused regions and therefore, the semiconductor device can have a higher breakdown voltage. Moreover, since the doping time is very short in the present invention, it is not difficult to keep the producing conditions constant, which leads to improvements in various properties of the resulting semiconductor device.

Figs. 3A to 3K are cross-sectional views showing successive steps of an embodiment of the semiconductor device manufacturing method according to the present invention. First, as shown in Fig. 3A, a $P^+$-type region 22 is formed in a lower surface of an $N^-$-type silicon substrate 21, and a silicon oxide film 24 is formed on an upper surface of the substrate in accordance with a predetermined pattern.

Then, wet-etching is conducted on the upper surface of the semiconductor substrate 21 to form recessed portions 25, 26 and 27 as shown in Fig. 3B. The silicon oxide film 24 functions as a mask during the wet-etching. In this embodiment, the wet-etching is conducted at room temperature, using $HF + HNO_3 + CH_3COOH$ as an etchant. Consequently, recessed portions each having a sectional contour with a gentle curvature are formed in the upper surface of the semiconductor substrate 21. With respect to the configurations of these recessed portions, further explanations will be given later.

Next, after selectively forming silicon oxide films 28 on the upper surface of the silicon substrate 21 as illustrated in Fig. 3C, P-type impurities are diffused into the substrate 21 through the recessed portion 25, 26 and 27 to form $P^+$-type regions 29, 30 and 31 as shown in Fig. 3D. More specifically, these $P^+$-type regions 29, 30 and 31 are formed as follows. A semiconductor wafer provided with a mask for impurity diffusion is introduced into a diffusion chamber in which the wafer is doped with P-type impurities such as boron. In this case, $BBr_3$ is used as a dopant material and oxygen is used as a carrier gas. While additionally introducing oxygen gas into the diffusion chamber via another supply system, a diffusion source is deposited on the surface of the semiconductor wafer by heating the wafer at a temperature within a range of 900 - 1000°C for several minutes to several ten minutes. Then, boron ions are driven in the surface of the semiconductor substrate by heating the wafer at a temperature within a range of 1000 - 1200°C for several ten minutes to several hours in an atmosphere of nitrogen, oxygen, vapor or their mixture.

If impurities are diffused into the substrate for a time period of several minutes to several ten minutes through the recessed portions 25, 26 and 27 as described above, the thus-obtained P+-type regions 29, 30 and 31 have a gently curved boundary when viewed in section, thereby effectively preventing a concentration of an electric field. Incidentally, as shown in Fig. 3D, a silicon oxide film 32 is formed over the surface of the silicon substrate 21 during this doping treatment.

After selectively removing the silicon oxide film 32 at such portions that correspond to the central portion and outermost peripheral portion of the substrate to expose the P+-type region and N--type region lying therebeneath as depicted in Fig. 3E, N-type impurities are diffused into the exposed regions to form N+-type regions 23 and 38, respectively. More specifically, these N+-type regions 23 and 38 are formed in the following manner. A semiconductor wafer in a state of Fig. 3E is introduced into a diffusion chamber in which the wafer is doped with N-type impurities such as phosphorus. In this embodiment, $POCl_3$ is used as a dopant material and oxygen is used as a carrier gas. While introducing oxygen gas into the diffusion chamber via another supply system simultaneously, a diffusion source is deposited on the surface of the semiconductor wafer by heating the wafer at a temperature within a range of 1000 - 1100°C for several minutes to several ten minutes. Then, phosphorus ions are driven in the surface of the semiconductor wafer by heating the substrate at a temperature within a range of 900 - 1100°C for several ten minutes to several hours in an atmosphere of nitrogen, oxygen, vapor or their mixture. During this doping treatment, a silicon oxide film 32 is again formed on the N+-type regions 23 and 38 and thus, the entire surface of the semiconductor substrate 21 is covered with the silicon oxide layer 32.

Then, as shown in Fig. 3G, the silicon oxide film 32 is selectively removed at portions corresponding to the recessed portion 27 and central portion of the substrate to partially expose the P+-type region 31 and N+-type region 38 lying beneath. After applying a resist 33 all over the surface of the wafer as illustrated in Fig. 3H, the substrate is subjected to a photolithographic treatment to selectively remove the resist 33 in such portions that cover the above-mentioned P+-type region 31 and N+-type region 38 in order to have them exposed again as shown in Fig. 3I. Then, as depicted in Fig. 3J, aluminum films 34 and 35 are formed on the upper and lower surfaces of the silicon substrate 21, respectively. Finally, the aluminum film 34 formed on the resist 33 is selectively removed by a lift-off treatment, so that a part of the aluminum film 34 is left on the P+-type region 31 as a gate and another part of the aluminum film 34 is left on the N+-type region 38 as a cathode, as illustrated in Fig. 3K. Incidentally, the aluminum film 35 on the lower surface functions as an anode.

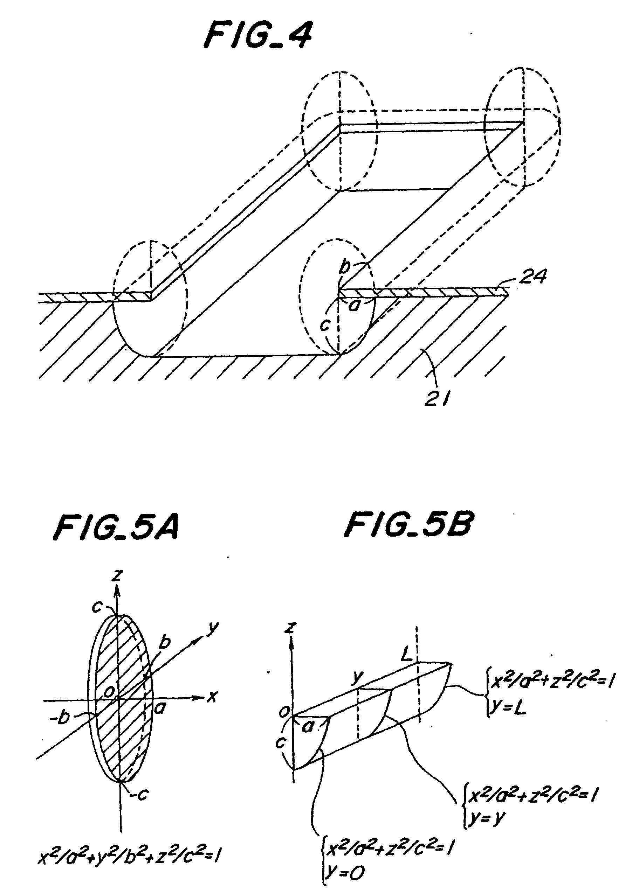

Fig. 4 is a diagram for explaining the configuration of a recessed portion formed in a surface of a semiconductor substrate in the semiconductor device according to the present invention. A silicon oxide film 24 having a rectangular opening is formed on a surface of a silicon substrate 21 as an etching mask and then, the silicon substrate 21 is partially wet-etched through this opening. Here, a plane parallel to the surface of the silicon substrate 21 is defined by x-y coordinates and a position in a direction perpendicular to this plane is defined by z coordinate. Since the wet-etching is an isotropic etching, a recessed portion formed by the wet-etching include portions that are respectively identical to a part of a spheroid. More specifically, when the origin of the coordinates is located on each of the four corners of the opening of the mask and the wet-etching proceeds to a point "a" on the x-axis, to a point "b" on the y-axis and to a point "c" on the z-axis as illustrated in Fig. 5A, the thus-obtained recessed portion has a surface which includes such portions that are respectively composed of one fourth of the spheroid represented by the following formula:

$$x^2/a^2 + y^2/b^2 + z^2/c^2 = 1,$$

wherein a = b = 0.5c - 1.2c.
The surface of the recessed portion also includes, at positions that correspond to the long sides L and short sides h of the opening of the mask, such portions that are respectively composed of one fourth of an elliptic cylinder represented by either of the following formulae:

$$x^2/a^2 + z^2/c^2 = 1 \ (y = 0 \sim L),$$

$$y^2/a^2 + z^2/c^2 = 1 \ (x = 0 \sim h).$$

Accordingly, when a recessed portion is formed by wet-etching, the resulting recessed portion has a surface which is partially constituted by the above-described rounded portions. Further, if impurities are diffused into the substrate through such a recessed portion, the thus-obtained impurity-diffused region can have a similarly rounded configuration even when the impurity diffusion is performed for a very short period of time.

As described heretofore, since the semiconductor device according to the present invention includes the semiconductor regions, each of which has a gently curved sectional contour and is formed by diffusing impurities into the semiconductor substrate through the surfaces of the recessed portions, a concentration of an electric field scarcely occurs during the operation of the device. This means that the semiconductor device according to the present invention has an improved breakdown voltage. Further, in the manufacturing method of the semiconductor device according to the present invention, since the semiconductor substrate is doped with impurities through the recessed portions formed in the surface of the substrate, each of the thus-obtained impurity-diffused regions has a gently curved sectional contour in spite of the shortness of the time period in which the impurity diffusion is conducted. Accordingly, a concentration of an electric field can be effectively avoided, thereby increasing the breakdown voltage of the device. In addition, since the doping time is very short, semiconductor devices having stable properties can be produced with high throughput by the manufacturing method of the present invention.

Incidentally, any semiconductor region formed by impurity diffusion naturally has a more or less rounded configuration. Accordingly, even in a case where a recessed portion is formed in a surface of a substrate by anisotropic etching such as reactive ion-etching, in which $Cl_2$ gas, $CHF_3$ gas or the like is utilized, and thus the recessed portion does not have a rounded sectional contour, an impurity-diffused region formed by doping the substrate with impurities through such a recessed portion can have such a sectional contour that has a somewhat curved portion at each corner of the recessed portion. Although an improvement attained in a breakdown voltage is rather small when compared with the improvement attained in the case where the recessed portion is formed by isotropic etching, a diffusion time required to obtain a higher breakdown voltage is shorter than that in the conventional method, because the impurities are diffused into the substrate through the side surface of the recessed portion in addition to the bottom thereof.

**Claims**

1. A semiconductor device comprising:

   a semiconductor substrate having a surface (1);
   a recess (4, 5, 6) formed in said surface of said semiconductor substrate; and
   a semiconductor region (7, 8, 9) formed by selectively doping a surface of said recess with impurities;

   **characterized in that** said recess (7, 8, 9) has a curved cross-sectional contour such that said surface includes curved portions, each of which is substantially identical to a part of a spheroid represented by the following formula:

$$x^2/a^2 + y^2/b^2 + z^2/c^2 = 1,$$

wherein x and y are orthogonal coordinates defining a plane which is parallel to said surface of said semiconductor substrate and z is a coordinate defining a position in a direction perpendicular to said plane.

2. The semiconductor device according to claim 1, wherein said semiconductor region (4, 5) is a guard ring.

3. A method of manufacturing a semiconductor device comprising the steps of:

   providing a recess (4, 5, 6) in a surface of a semiconductor substrate (1); and
   providing a semiconductor region (7, 8, 9) by selectively doping a surface of said recess with impurities;

   **characterized in that** said recess (7, 8, 9) has a curved cross-sectional contour such that said surface includes curved portions, each of which is substantially identical to a part of a spheroid represented by the following formula:

$$x^2/a^2 + y^2/b^2 + z^2/c^2 = 1,$$

wherein x and y are orthogonal coordinates defining a plane which is parallel to said surface of said semiconductor substrate and z is a coordinate defining a position in a direction perpendicular to said plane.

4. The method of manufacturing a semiconductor device according to claim 3, wherein said surface of said recess (4, 5) is doped with impurities to form a guard ring.

5. The method of manufacturing a semiconductor device according to claim 3 or 4, wherein the formation of said recess (4, 5, 6) is conducted by wet-etching, while using a mask which has an opening at a position corresponding to a portion of the substrate surface at which the recess is to be formed.

6. The method of manufacturing a semiconductor device according to claim 5, wherein said semiconductor substrate (1) is a silicon substrate and said mask is a silicon oxide film provided on said silicon substrate.

**Patentansprüche**

1. Halbleitervorrichtung, umfassend:

   ein Halbleitersubstrat mit einer Oberfläche (1);

   eine in der Oberfläche des Halbleitersubstrats ausgebildete Ausnehmung (4, 5, 6); und

   einen Halbleiterbereich (7, 8, 9), der durch selektives Dotieren einer Oberfläche der Ausnehmung mit Verunreinigungen gebildet ist;

   **dadurch gekennzeichnet, dass** die Ausnehmung (7, 8, 9) eine gekrümmte Querschnittskontur aufweist, so dass die Oberfläche gekrümmte Abschnitte aufweist, von denen jeder im Wesentlichen identisch mit einem Teil eines Sphäroids mit der folgenden Formel ist:

   $$x^2/a^2 + y^2/b^2 + z^2/c^2 = 1,$$

   worin x und y orthogonale Koordinaten sind, die eine Ebene definieren, die parallel zur Oberfläche des Halbleitersubstrats verläuft, und z eine Koordinate ist, die eine Position in einer Richtung senkrecht zu dieser Ebene definiert.

2. Halbleitervorrichtung nach Anspruch 1, worin der Halbleiterbereich (4, 5) ein Schutzring ist.

3. Verfahren zur Herstellung einer Halbleitervorrichtung, folgende Schritte umfassend:

   das Vorsehen einer Ausnehmung (4, 5, 6) in einer Oberfläche eines Halbleitersubstrats (1); und
   das Bereitstellen eines Halbleiterbereichs (7, 8, 9) durch selektives Dotieren einer Oberfläche der Ausnehmung mit Verunreinigungen;

   **dadurch gekennzeichnet, dass** die Ausnehmung (7, 8, 9) eine gekrümmte Querschnittskontur aufweist, so dass die Oberfläche gekrümmte Abschnitte aufweist, von denen jeder im Wesentlichen identisch mit einem Teil eines Sphäroids mit der folgenden Formel ist:

   $$x^2/a^2 + y^2/b^2 + z^2/c^2 = 1,$$

   worin x und y orthogonale Koordinaten sind, die eine Ebene definieren, die parallel zur Oberfläche des Halbleitersubstrats verläuft, und z eine Koordinate ist, die eine Position in einer Richtung senkrecht zur Ebene definiert.

4. Verfahren zur Herstellung einer Halbleitervorrichtung nach Anspruch 3, worin die Oberfläche der Ausnehmung (4, 5) mit Verunreinigungen dotiert ist, um einen Schutzring zu bilden.

5. Verfahren zur Herstellung einer Halbleitervorrichtung nach Anspruch 3 oder 4, worin die Bildung der Ausnehmung (4, 5, 6) durch Nassätzen durchgeführt wird, während eine Maske verwendet wird, die eine Öffnung an einer Position aufweist, die einem Abschnitt der Substratoberfläche entspricht, an dem die Ausnehmung auszubilden ist.

6. Verfahren zur Herstellung einer Halbleitervorrichtung nach Anspruch 5, worin das Halbleitersubstrat (1) ein Siliziumsubstrat ist und die Maske ein auf dem Siliziumsubstrat vorgesehener Siliziumoxidfilm ist.

**Revendications**

1. Dispositif semi-conducteur comprenant :

   un substrat semi-conducteur ayant une surface (1);
   un évidement (4, 5, 6) ménagé dans ladite surface dudit substrat semi-conducteur ; et
   une région semi-conductrice (7, 8, 9) formée en dopant sélectivement une surface dudit évidement avec des impuretés ;

   **caractérisé en ce que** ledit évidement (7, 8, 9) présente un contour courbé en section transversale de sorte que ladite surface présente des portions courbées dont chacune est sensiblement identique à une partie d'un sphéroïde représenté par la formule suivante :

   $$x^2/a^2 + y^2/b^2 + z^2/c^2 = 1,$$

   où x et y sont des coordonnées orthogonales définissant un plan qui est parallèle à ladite surface dudit substrat semi-conducteur et z est une coordonnée définissant une position dans une direction perpendiculaire audit plan.

2. Dispositif semi-conducteur selon la revendication 1, où ladite région semi-conductrice (4, 5) est une bague de protection.

3. Procédé de fabrication d'un dispositif semi-conducteur comprenant les étapes consistant à :

   réaliser un évidement (4, 5, 6) dans une surface d'un substrat semi-conducteur (1) ; et
   réaliser une région semi-conductrice (7, 8, 9) en dopant sélectivement une surface dudit évidement avec des impuretés ;

**caractérisé en ce que** ledit évidement (7, 8, 9) présente un contour courbé en section transversale de sorte que ladite surface comprend des portions courbées dont chacune est sensiblement identique à une partie d'un sphéroïde représenté par la formule suivante :

$$x^2/a^2 + y^2/b^2 + z^2/c^2 = 1,$$

où x et y sont des coordonnées orthogonales définissant un plan qui est parallèle à ladite surface dudit substrat semi-conducteur et z est une coordonnée définissant une position dans une direction perpendiculaire audit plan.

4. Procédé de fabrication d'un dispositif semi-conducteur selon la revendication 3, où ladite surface dudit évidement (4, 5) est dopée avec des impuretés pour former une bague de protection.

5. Procédé de fabrication d'un dispositif semi-conducteur selon la revendication 3 ou 4, où la formation dudit évidement (4, 5, 6) est effectuée par une attaque à l'acide en utilisant un masque qui a une ouverture à une position correspondant à une portion de la surface du substrat à laquelle l'évidement doit être formé.

6. Procédé de fabrication d'un dispositif semi-conducteur selon la revendication 5, où ledit substrat semi-conducteur (1) est un substrat en silicium, et ledit masque est un film d'oxyde de silicium réalisé sur ledit substrat en silicium.

## FIG. 1

## FIG. 2

# FIG_3A

24

N⁻

21

22    P⁺

# FIG_3B

25 26   27

N⁻

21

P⁺   22

# FIG_3C

28 25 26   27

N⁻

21

P⁺   22

# FIG_3D

32 25 26 27

N⁻

21

29   P⁺   P⁺   P⁺   P⁺   22
       30  P⁺
          31

# FIG_3E

32 25 26 27

N⁻

21

29 30 31   P⁺   22

# FIG_3F

32 25 26   38   27 33 26 25

23

N⁻

21

P⁺   22

# FIG_3G

32 25 26   27   38 27 26 25

23

N⁻

21

29 30 31   P⁺   22

# FIG_3H

25 26 33   38

N⁻

21

29 30 31   P⁺   22

# FIG_3I

33 25 26 27   38   27 26 25

32

23

N⁻

21

29 30 31   P⁺   22

# FIG_3J

33   25 26 27 34 38   27 26 25

32

23

N⁻

21

29 30 31   P⁺   22 35

# FIG_3K

26 Gate Cathode   37 27 26 25
25   33   34   36
23

N⁻

21

29 30 31   P⁺   38 35 22
       Anode

EP 0 681 326 B1

# FIG_4

# FIG_5A

$$x^2/a^2+y^2/b^2+z^2/c^2=1$$

# FIG_5B

$$\begin{cases} x^2/a^2+z^2/c^2=1 \\ y=L \end{cases}$$

$$\begin{cases} x^2/a^2+z^2/c^2=1 \\ y=y \end{cases}$$

$$\begin{cases} x^2/a^2+z^2/c^2=1 \\ y=0 \end{cases}$$